(19) Europäisches Patentamt
European Patent Office
Office européen des brevets

(11) **EP 2 233 937 B1**

(12) **FASCICULE DE BREVET EUROPEEN**

(45) Date de publication et mention
de la délivrance du brevet:
**18.12.2013 Bulletin 2013/51**

(51) Int Cl.:
***G01R 31/36*** *(2006.01)*

(21) Numéro de dépôt: **10157067.9**

(22) Date de dépôt: **19.03.2010**

(54) **Procédé de détermination de l'état de santé d'une batterie**

Verfahren zur Bestimmung des Gesundheitszustands einer Batterie

Method for determining the state of health of a battery

(84) Etats contractants désignés:
**DE FR GB**

(30) Priorité: **24.03.2009 FR 0901371**

(43) Date de publication de la demande:
**29.09.2010 Bulletin 2010/39**

(73) Titulaire: **Saft Groupe S.A.**
**93170 Bagnolet (FR)**

(72) Inventeurs:
• **Desprez, Philippe**
**33320, LE TAILLAN MEDOC (FR)**
• **Laflaquiere, Philippe**
**33800, BORDEAUX (FR)**

(74) Mandataire: **Hirsch & Associés**
**58, avenue Marceau**
**75008 Paris (FR)**

(56) Documents cités:
**EP-A- 1 688 754     US-A1- 2003 030 414**

**Description**

La présente invention se rapporte à un procédé de détermination de l'état de santé d'une batterie comprenant au moins un accumulateur de courant.

Un générateur électrochimique ou accumulateur de courant (ces deux termes sont équivalents) est un dispositif de production d'électricité dans lequel de l'énergie chimique est convertie en énergie électrique. L'énergie chimique est constituée par des composés électrochimiquement actifs déposés sur au moins une face d'électrodes disposées dans l'accumulateur. L'énergie électrique est produite par des réactions électrochimiques au cours d'une décharge de l'accumulateur. Les électrodes, disposées dans un conteneur, sont connectées électriquement à des bornes de sortie de courant qui assurent une continuité électrique entre les électrodes et un consommateur électrique auquel l'accumulateur est associé.

La batterie est destinée à fournir de l'énergie électrique à une application extérieure et un circuit de charge est généralement prévu auquel la batterie peut être branchée pour recharger les accumulateurs. Afin d'augmenter la puissance délivrée, il est connu d'associer plusieurs accumulateurs étanches entre eux pour former une batterie. La batterie peut ainsi comporter une ou plusieurs branches parallèles d'accumulateurs reliés en série. La gestion de la charge et de la décharge de la batterie peut alors être organisée et contrôlée pour équilibrer la charge et décharge des différents accumulateurs les uns par rapport aux autres. Un système de gestion comprenant des capteurs de mesures et un circuit électronique de contrôle, plus ou moins évolué selon les applications, peut être associé à la batterie.

L'état de charge (SOC pour State of Charge en anglais) et l'état de santé (SOH pour State of Health en anglais) sont des informations utiles au système électronique de gestion de la batterie pour optimiser son utilisation et sa durée de vie. Typiquement, l'état de charge SOC est déterminé comme la quantité d'énergie disponible dans la batterie ; il peut être calculé par intégration du courant de charge/décharge en fonction du temps. L'état de santé SOH de la batterie permet de déterminer l'état de vieillissement de la batterie entre un état neuf et un état de panne ; il peut être calculé comme le rapport de la résistance de la batterie à un instant donné sur la résistance de la batterie à l'état neuf à même température.

Une détermination de l'état de santé de la batterie aussi directe que les rapports de la résistance n'est cependant pas toujours fiable et peut conduire au remplacement d'une batterie encore en bon état ou, au contraire, à une non anticipation d'une défaillance qui porte préjudice à l'application à laquelle la batterie est destinée.

Une première méthode de détermination de l'état de santé d'une batterie consiste à réaliser des vérifications de maintenance régulières pour déterminer la résistance et/ou la capacité interne de la batterie - hors connexion à l'application extérieure ou au chargeur. La batterie n'est cependant pas disponible pendant ces opérations de maintenance, ce qui peut être préjudiciable pour certaines applications. De plus, entre deux maintenances, le SOH n'est pas évalué.

Une autre méthode de détermination de l'état de santé d'une batterie consiste à suivre les valeurs de température, éventuellement de tension et éventuellement de courant échangé afin de déterminer une valeur de SOH prédictive en fonction de tests préalablement réalisés en laboratoire. Toute déviation du comportement de la batterie par rapport à un comportement nominal ne sera cependant pas détectée. Une telle méthode de détermination n'est pas fiable.

Le document US-A-7 202 632 propose de mesurer la résistance d'une batterie lorsque certains critères (de température et de variation de courant) sont réunis, puis de calculer le SOH à partir de cette mesure comme le ratio de la résistance mesurée sur la résistance initiale avec des pondérations. Les pondérations définies dans ce brevet correspondent à un filtre temporel. Les mesures ne sont cependant pas réalisées en continu et le SOH peut ne pas être évalué pendant assez longtemps si les conditions de mesure ne sont pas remplies.

Le document US-A-7 009 401 propose de mesurer la résistance de la batterie à différentes fréquences et avec certaines conditions de mesure (par exemple courant de décharge maintenu constant pendant la mesure). Cette méthode ne propose donc pas non plus une mesure en continu de la résistance de la batterie quelles que soient ses conditions de fonctionnement.

Le document US-A-7 324 902 décrit une méthode de détermination de l'état de charge et de l'état de santé d'une batterie en définissant un modèle complexe de batterie et en réalisant une détermination récursive à partir de ce modèle et de relations fonctionnelles entre des paramètres initiaux. Cette méthode n'introduit pas de pondération suivant l'état de la batterie.

Le document US-A-7 072 871 propose de mesurer un certain nombre de paramètres de la batterie et de calculer l'état de santé par une logique floue. Cette méthode ne prend pas en compte l'état de la batterie mais uniquement le type de batterie utilisée.

Le document US-A-6 54 954 décrit l'utilisation d'un filtre de Kalman pour déterminer l'état de charge de la batterie. Le document US-A-2006/0111854 décrit une méthode de détermination de paramètres internes de la batterie basée sur l'utilisation d'un filtre de Kalman. L'algorithme de Kalman permet d'estimer efficacement les états d'un système dynamique à partir de mesures incomplètes ou bruitées. Néanmoins, l'algorithme de Kalman seul n'a pas une stabilité suffisante pour fournir une valeur stable de l'état de santé d'une batterie. En effet, par définition, l'algorithme de Kalman augmente la variation sur le paramètre (par exemple la résistance) qu'il suit lorsque le paramètre s'éloigne du modèle, ce qui peut être le cas lorsque la batterie se situe à faible SOC ou avec une forte variation de température. Dans de telles conditions, l'algorithme de Kalman ne fait qu'amplifier l'erreur sur la détermination du SOH.

La publication « Li-ion battery SOC estimation method based on the reduced order Kalman filtering » de J. Lee et al, Journal of power source, 174, 2007 (9-15) propose une détermination de la résistance de la batterie par un algorithme de Kalman avec une pondération en fonction du SOC. Les valeurs déterminées par l'algorithme sont rejetées dans les zones de fort ou de faible SOC ou de forts courants. Cette pondération permet de rendre l'algorithme de Kalman plus robuste mais ne permet pas de suivre en continu l'état de santé de la batterie quelles que soient les conditions de fonctionnement de la batterie.

On connaît le document EP-A-1 688 754 qui décrit un procédé de mesure de l'état de charge. Cependant le procédé décrit ne prend pas en compte la fiabilité des mesures.

Il existe donc un besoin pour une méthode de détermination de l'état de santé d'une batterie qui soit fiable et qui présente davantage de stabilité et de robustesse que les méthodes connues.

A cet effet, l'invention propose d'évaluer l'état de santé SOH d'une batterie en continu à partir d'une détermination en temps réel de sa résistance et par une correction suivant son état (température, SOC, courant le traversant). L'état de santé de la batterie à un instant donné est ainsi déterminé à partir de l'état de santé de la batterie à un instant précédent corrigé en fonction de la résistance déterminée à l'instant donné et pondéré avec des coefficients de confiance fonction du courant et/ou de la température et/ou l'état de charge à l'instant donné.

Plus particulièrement, l'invention concerne un procédé de détermination d'un état de santé d'une batterie selon la revendication 1.

Selon un mode de réalisation, le procédé comprend en outre une étape de calcul d'un indice de confiance sur la valeur de l'état de santé de la batterie déterminée à l'instant donné, ledit indice de confiance étant calculé à partir de l'indice de confiance de l'instant précédent et du au moins un coefficient de confiance.

Selon un mode de réalisation, le procédé comprend en outre une étape de filtrage temporel de la valeur de l'état de santé de la batterie déterminée à l'instant donné avec une constante de temps du filtre choisie telle que le rapport de la constante de temps du filtre sur le pas temporel de la détermination soit supérieur ou égal à $10^4$.

Selon un mode de réalisation, le procédé comprend en outre une étape de filtrage temporel de la valeur de la résistance déterminée à l'instant donné avec une constante de temps du filtre choisie telle que le rapport de la constante de temps du filtre sur le pas temporel de la détermination soit supérieur ou égal à 1000.

Selon un mode de réalisation, dans lequel le pas temporel de la détermination en temps réel est choisi entre 10 ms et 1 s.

Selon un mode de réalisation, la détermination de la résistance d'au moins un accumulateur à l'instant donné est réalisée par mesures de courant et de tension sur l'accumulateur.

Selon un autre mode de réalisation, la détermination de la résistance d'au moins un accumulateur à l'instant donné est réalisée par un algorithme de Kalman.

L'invention concerne aussi un système électronique de gestion d'un état de santé d'une batterie selon la revendication 9.

Selon un mode de réalisation, le système comprend en outre des moyens de contrôle de la charge et/ou de la décharge de la batterie en fonction de l'état de santé déterminé.

L'invention concerne également une batterie comprenant au moins un accumulateur électrochimique et un système électronique selon l'invention.

D'autres caractéristiques et avantages de l'invention apparaîtront à la lecture de la description qui suit, donnée à titre d'exemple et en référence aux figures qui montrent :

- Figure 1, une fonction de pondération pour la détermination d'un indice de confiance suivant le courant ;
- Figure 2, une fonction de pondération pour la détermination d'un indice de confiance suivant la température;
- Figure 3, une fonction de pondération pour la détermination d'un indice de confiance suivant le SOC ;
- Figure 4, un graphe illustrant la détermination du SOH selon un premier mode de réalisation de l'invention ;
- Figure 5, un schéma d'un système selon l'invention.

L'invention concerne un procédé de détermination de l'état de santé SOH d'une batterie comprenant au moins un accumulateur de courant. L'invention s'applique à tout type d'accumulateur, comme par exemple Li-ion, NiMH, NiCd ou autre. L'invention propose de déterminer l'état de santé de la batterie en temps réel. Le SOH ainsi déterminé est réellement utilisable par un système de gestion électronique de la batterie, du fait de sa justesse, de sa stabilité, de sa robustesse et du temps de réponse rapide.

Le procédé selon l'invention comprend une étape consistant à déterminer en temps réel la résistance d'au moins un accumulateur de la batterie. On peut mesurer la résistance de chaque accumulateur et effectuer une moyenne, ou prendre la résistance maximale, pour déterminer la résistance à utiliser dans le calcul de l'état de santé de la batterie ;

on peut aussi mesurer la résistance directement aux bornes de sortie de la batterie sans mesurer des valeurs au niveau de chaque accumulateur. Par la suite, on se référera à une mesure de la résistance aux bornes d'un accumulateur.

On entend par « détermination en temps réel » une mesure ou une estimation régulière avec un pas temporel n inférieur à 1 seconde. Typiquement, le pas temporel sera compris entre 10 ms et 1s, par exemple 100 ms. En deçà de 10 ms, l'électronique de traitement et les capteurs de mesure (courant, tension, température) peuvent manquer de stabilité. Au-delà de 1 s, la justesse de la détermination peut être affectée.

Le procédé selon l'invention comprend aussi une étape consistant à déterminer en en temps réel l'état de santé de la batterie à un instant donné $SOH_n$ à partir de l'état de santé de la batterie à un instant précédent $SOH_{n-1}$ corrigé en fonction de ladite résistance à l'instant donné et pondéré avec des coefficients de confiance fonction du courant et/ou de la température et/ou l'état de charge à l'instant donné. Ainsi, quel que soit l'état de la batterie, le SOH est déterminé en permanence ou continuellement. Aucune valeur de SOH n'est rejetée, contrairement à ce que propose la publication « Li-ion battery SOC estimation method based on the reduced order Kalman filtering » de J. Lee mentionnée plus haut, mais les coefficients de confiance permettent de tenir compte des mauvaises conditions de fonctionnement de la batterie comme cela sera expliqué en détails plus bas.

Une première étape du procédé de l'invention consiste donc à évaluer la résistance en ligne de la batterie, c'est-à-dire sans déconnecter la batterie de l'application extérieure ni du chargeur. Des capteurs sont agencés dans la batterie pour fournir notamment des valeurs de courants échangés (au niveau de chaque branche parallèle d'accumulateurs ou au niveau d'une borne de sortie de la batterie), des valeurs de tensions (aux bornes de chaque accumulateur ou aux bornes de sortie de la batterie) et des valeurs de températures.

On détermine ainsi à chaque instant n une valeur de la résistance $R_{mes,n}$, par exemple dans un calculateur. Selon un mode de mise en oeuvre, la valeur de la résistance $R_{mes,n}$ peut être déterminée par mesures de courant et de tension sur l'accumulateur selon la relation :

$$R_{mes,n} = (V_n - E_{o,n})/I_n$$

Avec $V_n$, la tension mesurée aux bornes de l'accumulateur à l'instant n,
$E_{o,n}$, la tension théorique à vide en fonction du SOC à l'instant n, et
$I_n$, le courant mesurée en entrée ou sortie de l'accumulateur à l'instant n.

La tension théorique à vide $E_{o,n}$ peut être déterminée, sur une batterie de type Lithium-Ion, à partir d'un algorithme de base suivant :

Si le courant est faible, la tension est assimilée à la « fem » (force électromotrice ou OCV pour Open Circuit Voltage en anglais) de l'accumulateur. On a alors $E_{o,n}=V_n$. L'état de charge de l'accumulateur est fonction de la force électromotrice, avec SOC = f(fem). Pour des courants supérieurs, on effectue ce que l'on appelle un recalage : l'état de charge à un instant donné $SOC_n$ est déterminé à partir de ce recalage par un compteur coulométrique et par la capacité de l'élément selon la relation :

$$SOC_n = SOC_{n-1} + Ah/capa$$

Et $E_{o,n}$ est déterminée par la relation $E_{o,n}=fem=f'^{1}(SOC_n)$.

La valeur de la résistance $R_{mes,n}$ ainsi déterminée peut être filtrée avec un filtre temporel, par exemple un algorithme dit RTA pour « Run Time Averaging » selon la relation suivante :

$$R'_{mes,n} = (r*R_{mes,n-1} + R_{mes,n})/(r+1)$$

Avec r la constante de temps du filtre choisie telle que le rapport de la constante de temps du filtre sur le pas de mesure $(r/(t_n-t_{n-1}))$ soit supérieur ou égal à 1000 afin de bien stabiliser la mesure réalisée.

Selon un autre mode de mise en oeuvre, la valeur de la résistance $R_{mes,n}$ peut être déterminée par un algorithme de Kalman, comme par exemple l'algorithme décrit dans la publication de J. Lee et al mentionnée plus haut.

Une deuxième étape du procédé peut consister à déterminer une valeur d'état de santé intermédiaire pour un instant donné $(SOH_{int,n})$ défini par la relation :

$$SOH_{int,n}=R_{mes,n}/R_{new}$$

avec $R_{new}$, la résistance nominale de l'accumulateur ou de la batterie à neuf à la température donnée au moment de la mesure. Typiquement, à chaque batterie est associée une table de détermination de sa résistance nominale en fonction de la température. Par exemple, pour une batterie comprenant 6 accumulateurs séries Li-ion (référence commerciale VL6P du demandeur), la table de détermination de sa résistance nominale en fonction de la température est la suivante :

$$T = [-50\ -25\ -20\ -10\ 0\ 10\ \mathbf{25}\ 40\ 55\ 100];$$

$$R_{new} = [100\ 21\ 16\ 11.2\ 7.5\ 5.3\ \mathbf{3.4}\ 2.3\ 1.7\ 1.7]/1000.$$

Ainsi, à 25°C, la résistance à vide de la batterie est 3.4 mΩ.

Du fait de l'extrême complexité du comportement des accumulateurs d'une batterie, notamment du fait de leur comportement non linéaire en fonction du courant, de la température et des constantes de temps associées, les mesures $R_{mes,n}$ prises isolément et donc les valeurs d'états de santé intermédiaires $SOH_{int,n}$ ne sont pas fiables.

Une troisième étape du procédé consiste à déterminer des coefficients de confiance. Ces coefficients de confiance sont introduits afin de prendre en compte la fiabilité de la résistance en fonction du courant, de la température, de l'état de charge, et du temps. A toutes ces variables, il faut associer leur caractère dynamique (dI/dt, dT/dt, dSOC/dt).

L'invention propose de définir des coefficients de confiance de la résistance déterminée à l'instant donné $R_{mes,n}$ avec toutes ou certaines des variables de courant, température et SOC. Ces coefficients de confiance sont ensuite utilisés afin de pondérer l'état de santé $SOH_n$ déterminé à un instant donné. Ces coefficients de confiance peuvent aussi être utilisés pour déterminer un indice de confiance de la valeur de l'état de santé $SOH_n$ déterminée à un instant donné.

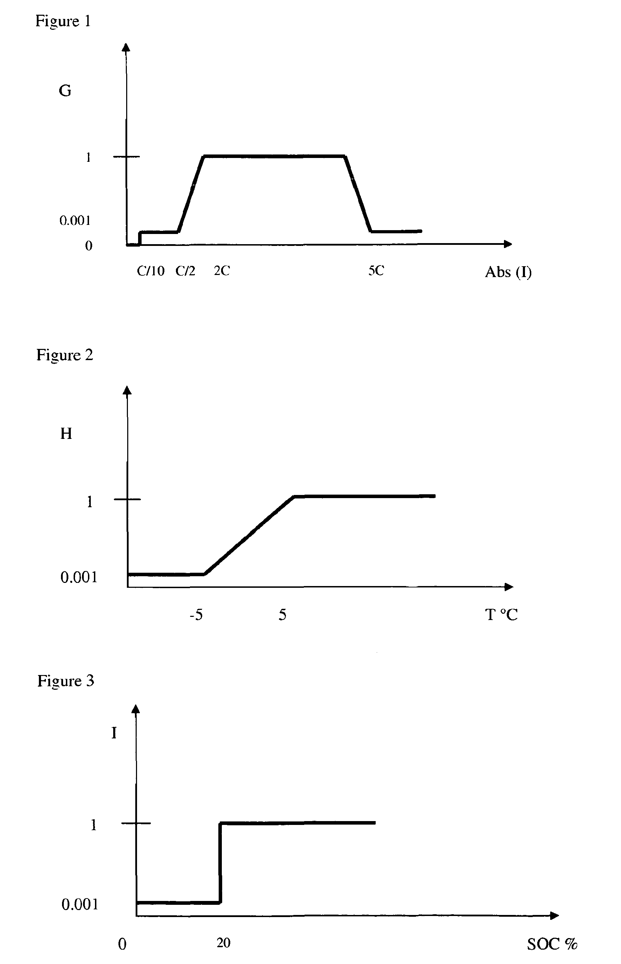

Les figures 1 à 3 illustrent des fonctions de pondération qui peuvent être utilisées pour déterminer les coefficients de confiance du courant, de la température et du SOC respectivement.

La fonction de pondération de la figure 1 permet de déterminer un coefficient de confiance G suivant le courant. Le coefficient de confiance G est exprimé en relation avec le régime de charge et de décharge. On entend par « décharge », l'opération par laquelle une batterie fournit à un circuit extérieur et dans des conditions spécifiées de l'énergie électrique produite dans les accumulateurs. On entend par « charge », l'opération pendant laquelle un accumulateur ou une batterie d'accumulateurs reçoit de l'énergie électrique d'un circuit extérieur, qui conduit à des modifications chimiques à l'intérieur de l'accumulateur et ainsi au stockage de l'énergie sous forme d'énergie chimique. Dans ce contexte, on entend par « régime de charge », le courant électrique auquel on charge un accumulateur ou une batterie d'accumulateurs. Le régime de charge est le courant de référence I=C/n où C est la capacité assignée déclarée par le fabricant et n est le temps de base en heures pour lequel la capacité assignée est déclarée. De même, on entend par « régime de décharge », le courant électrique auquel est déchargé une batterie. Le régime de décharge est calculé en divisant la capacité assignée par le temps de décharge, ce qui conduit à un courant électrique.

Par exemple, lorsque le courant mesuré en valeur absolue (en charge ou en décharge) est compris entre 2 et 4 fois la capacité de la batterie (ou de l'accumulateur, selon la prise de mesure), le coefficient de confiance suivant le courant est fixé à 1. Au-delà de 5C et entre C/2 et C/10, le coefficient de confiance n'est que de 0.001, avec une décroissance linéaire entre 4C et 5C et entre 2C et C/2. En deçà de C/10, la mesure est rejetée, le coefficient de confiance étant nul. Le seul cas où la mesure de la résistance est rejetée correspond au cas où elle ne peut être mesurée : la résistance en ligne ne peut être mesurée que si l'accumulateur est sollicité avec un courant non nul.

La fonction de pondération de la figure 2 permet de déterminer un coefficient de confiance H suivant la température. Par exemple, lorsque la température mesurée est supérieure à 5°C, le coefficient de confiance suivant la température est de 1 alors qu'en dessous de -5°C, le coefficient de confiance suivant la température est de 0.001 avec une décroissance linéaire entre les deux valeurs.

La fonction de pondération de la figure 3 permet de déterminer un coefficient de confiance I suivant le SOC. Par exemple, lorsque le SOC est supérieur à 20%, le coefficient de confiance suivant le SOC est de 1 alors qu'en dessous de 20%, il ne sera que de 0.001.

On peut ainsi déterminer, pour chaque mesure effectuée à chaque instant $R_{mes,n}$, des coefficients de confiance G, H, I qui peuvent éventuellement être développés selon la dérivée ou l'intégrale des fonctions de pondération définies ci-dessus. Les coefficients de confiance augmentent lorsque la fiabilité de la résistance devient importante en fonction du courant, des conditions de température, et/ou d'état de charge. Ceci est en particulier vrai dans les exemples précédents. Pour un courant faible, la résolution en tension ne permet pas d'avoir une mesure précise de la résistance, d'où un faible coefficient de confiance G. A basse température, la résistance est fortement sensible à une variation de la température, ce qui induit un faible coefficient de confiance H. A faible état de charge, la résistance est très sensible à une variation de l'état de charge, ce qui induit alors un faible coefficient de confiance I.

Ces coefficients de confiance peuvent ensuite être utilisés pour pondérer la détermination de l'état de santé de la batterie à un instant donné, comme cela est détaillé plus bas. Ces coefficients de confiance peuvent aussi être utilisés pour déterminer un indice de confiance sur la valeur déterminée de l'état de santé de la batterie à un instant donné, comme cela est détaillé plus bas.

Une quatrième étape consiste ensuite à déterminer une valeur d'état de santé de la batterie à un instant donné $SOH_n$. Comme indiqué plus haut, la définition classique de l'état de santé consistant à calculer le rapport entre la résistance mesurée et la résistance à vide n'est pas fiable, et surtout n'est pas suffisamment stable pour être utilisé par un système de gestion électronique de la batterie. L'invention propose de déterminer la valeur de l'état de santé à un instant donné à partir de l'état de santé de la batterie à un instant précédent corrigé en fonction de la résistance déterminée à l'instant donné et pondéré avec des coefficients de confiance fonction du courant et/ou de la température et/ou l'état de charge à l'instant donné.

Selon un exemple utile à la compréhension de l'invention, une méthode booléenne est utilisée sans utilisation de la valeur de l'état de santé intermédiaire $SOH_{int,n}$ défini plus haut.

La loi de détermination booléenne tient compte des coefficients de confiance déterminés à partir des fonctions de pondération sur le courant, la température et le SOC. Cette loi de détermination booléenne de l'état de charge à un instant donné $SOH_n$ peut s'écrire de la façon suivante :

Si $(R_{mes,n}) > aa*R_n + bb$,
avec $Rn = SOH_{n-1}*R_{new}$, et avec $aa$, $bb$ des coefficients décimaux de détermination de la relation booléenne
alors $SOH_n = SOH_{n-1} + a * (G*H*I)$
sinon $SOH_n = SOH_{n-1} - b * (G*H*I)$
avec $a$ et $b$ des coefficients décimaux de correction de la valeur de l'état de santé de la batterie à l'instant donné.

Cette loi booléenne peut utiliser une hystérésis :

Si $(R_{mes,n}) > aa*R_n + bb$,
alors $SOH_n = SOH_{n-1} + a *(G*H*I)$
sinon si $(R_{mes,n}) < (2-aa)*R_n - bb$
alors $SOH_n = SOH_{n-1} - a * (G*H*I)$
sinon $SOH_n = SOH_{n-1}$
avec les mêmes définitions que précédemment.

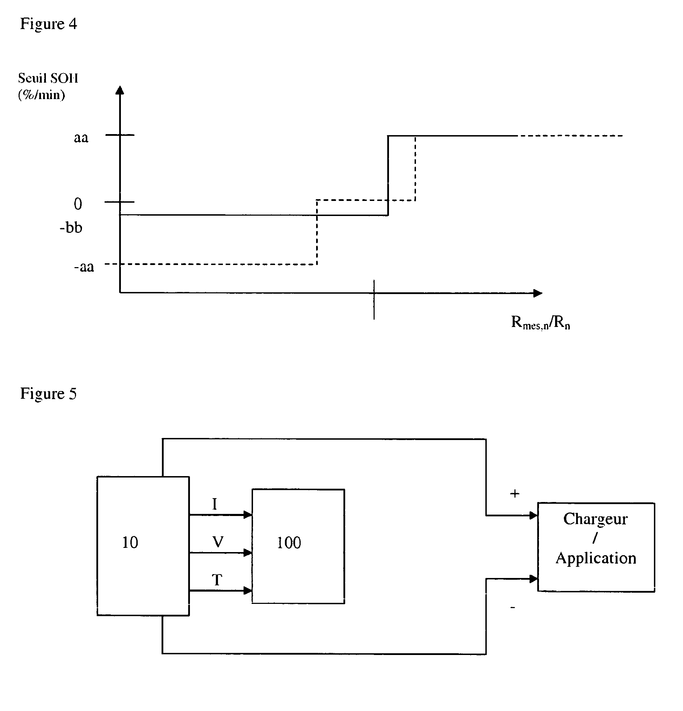

La figure 4 illustre schématiquement la détermination booléenne de la valeur de l'état de santé de la batterie à un instant donné à partir de l'état de santé de la batterie à un instant précédent, sans hystérésis (trait plein) ou avec une hystérésis (trait pointillé). Par exemple, $aa=1.05$ et $bb=0.03*R_{new}$ ; et $a=0.001$ et $b=0.00001$ ; et $t_n-t_{n-1}= 100$ ms. Avec de tels coefficients, la correction n'intervient que si la variation sur la résistance est supérieure à 5% et si l'écart par rapport à la résistance de la batterie neuve est supérieur à 3%.

Les relations ci-dessus montrent bien que les coefficients de confiance G, H et I vont permettre de pondérer la valeur du SOH déterminée à un instant donné. Notamment, si les conditions de fonctionnement sont mauvaises, c'est-à-dire si au ou plusieurs indices de confiance sont faibles, la valeur du SOH à un instant donné restera proche de la valeur précédente afin de conserver la continuité de la détermination. Lorsque les coefficients de confiance G, H, I sont proches de 1, la correction de la valeur du SOH à un instant donné peut être effectuée à partir de la valeur précédente et en fonction de la résistance mesurée. Ainsi, une fois les mauvaises conditions de fonctionnement dépassées (faible SOC ou faible température par exemple), la détermination du SOH se poursuit avec des corrections plus importantes en fonction de la résistance mesurée.

Notamment, un indice de confiance peut être associé à la valeur d'état de santé $SOH_n$ déterminée à un instant donné. Par exemple, l'indice de confiance peut être déterminé selon la relation suivante :

$IndConf\_SOH_n = [IndConf\_SOH_{n-1} + a*(G*H*I)] / (1+a)$

Avec G, H et I les coefficients de confiance définis plus haut et $a$ le coefficient de correction de la valeur de l'état de santé de la batterie à l'instant donné, défini dans la loi booléenne.

Cet indice de confiance $IndConf\_SOH_n$ permet de traiter comme il se doit la valeur du SOH déterminée à un instant donné. Ainsi, sans interrompre la détermination du SOH en rejetant des valeurs parce que les conditions de fonctionnement sont mauvaises, l'indice de confiance permet d'identifier des valeurs de SOH déterminées dans de mauvaises conditions et de traiter ces valeurs en conséquence. Par exemple, une logique floue suivant le SOH et l'indice de confiance peut être utilisée dans un système de gestion électronique de la batterie afin de déclencher des alarmes seulement lorsque le SOH est mauvais avec un bon indice de confiance et/ou lorsque l'indice de confiance reste inférieur à une valeur seuil pendant une durée importante.

Par ailleurs, les valeurs d'état de santé déterminées à un instant donné $SOH_n$ peuvent en outre être filtrées avec un filtre temporel, par exemple l'algorithme RTA présenté plus haut :

$$SOH'_n = (\ x*\ SOH_{n-1} + SOH_n)\ /\ (x+1)$$

Avec x la constante de temps du filtre choisie telle que le rapport de la constante de temps du filtre sur le pas de mesure $(x/(t_n-t_{n-1}))$ soit supérieur ou égal à $10^4$ afin de bien stabiliser la valeur d'état de santé déterminée.

Selon un autre exemple, l'état de santé de la batterie à un instant donné $SOH_n$ est déterminé en utilisant la valeur de l'état de santé intermédiaire $SOH_{int,n}$ défini plus haut. L'état de santé de la batterie à l'instant n peut ainsi être déterminé à partir de la relation suivante :

$$SOH_n = SOH_{n-1} + (G \cdot H \cdot I) \cdot SOH_{int,n}$$

L'état de santé de la batterie est bien déterminé à l'instant n à partir de l'état de santé de la batterie à un instant précédent corrigé en fonction de la résistance à l'instant donné $R_{mes,n}$ puisque l'état de santé intermédiaire $SOH_{int,n}$ est directement calculé à partir de la résistance à l'instant n.

Comme dans le premier exemple, les coefficients de confiance G, H et I vont permettre de pondérer la valeur du SOH déterminée à un instant donné. Si les conditions de fonctionnement sont mauvaises, la valeur du SOH à un instant donné restera proche de la valeur précédente afin de conserver la continuité de la détermination. Lorsque les coefficients de confiance G, H, I sont proches de 1, la correction de la valeur du SOH à un instant donné peut être effectuée à partir de la valeur précédente et en fonction l'état de santé intermédiaire tenant compte de la résistance mesurée.

L'invention propose de filtrer temporellement la valeur de l'état de santé déterminé à l'instant n avec une constante de temps x de l'ordre de 1000s à 10000s pour un pas de mesure de 100ms afin de bien stabiliser la valeur de SOH.

$$SOH_n = \frac{x \cdot SOH_{n-1} + (G \cdot H \cdot I) \cdot SOH_{int,n}}{x + (G \cdot H \cdot I)}$$

L'indice de confiance sur la valeur d'état de santé de la batterie ainsi déterminée peut s'exprimer selon la relation suivante :

$$IndConf\_SOH_n = [x*IndConf\_SOH_{n-1} + (G*H*I)]\ /\ (x+1)$$

Avec G, H et I les coefficients de confiance définis plus haut et x la constante de temps du filtre temporel.

Comme expliqué précédemment, cet indice de confiance $IndConf\_SOH_n$ permet de traiter la valeur du SOH déterminée à un instant donné en lui accordant plus ou moins d'importance au niveau du système de gestion électronique de la batterie.

La figure 5 illustre schématiquement un système selon l'invention. Une batterie 10 est destinée à être électriquement reliée à une application (pour fournir un courant) ou à un chargeur (pour recharger ses accumulateurs). Un système électronique de gestion 100 peut être associé à la batterie 10. Des capteurs sont prévus pour fournir au système de gestion 100 des valeurs de courant, tension et température. Les capteurs fournissent ces valeurs en en temps réel, avec un pas de mesure compris entre 10ms et 1s.

Le système électronique de gestion 100 comprend un calculateur (type microprocesseur) afin de déterminer en temps réel l'état de santé de la batterie selon l'un des modes de réalisation décrits plus haut. Le calculateur du système électronique de gestion 100 peut également calculer un indice de confiance de la valeur de l'état de santé à un instant donné, selon l'invention décrite ci-dessus. A partir de la valeur d'état de santé de la batterie $SOH_n$ et à partir de l'indice de confiance associé $IndConf\_SOH_n$, le système électronique de gestion 100 peut optimiser l'utilisation de la batterie selon différentes logiques. Le système électronique de gestion 100 peut notamment commander une interruption de la charge et/ou l'envoi de signaux d'alarme vers l'application.

Les modes de réalisation décrits ci-dessus et les figures doivent être considérés comme ayant été présentés à titre illustratif et non restrictif, et l'invention n'est pas censée être limitée aux détails fournis ici mais peut être modifiée en restant dans le cadre de la portée des revendications annexées. En particulier, les fonctions de pondération peuvent être adaptées selon le type de batterie et les applications.

## Revendications

1.   Un procédé de détermination d'un état de santé (SOH) d'une batterie comprenant au moins un accumulateur de courant, l'état de santé étant défini comme un état de vieillissement de la batterie entre un état neuf et un état en panne, le procédé comprenant les étapes consistant à:

   - déterminer un état de charge (SOC) d'au moins un accumulateur ;
   - déterminer en temps réel une résistance d'au moins un accumulateur ($R_{mes,n}$) ;
   - déterminer au moins un coefficient de confiance (G, H, I) prenant en compte la fiabilité de la résistance en fonction d'au moins une variable choisie parmi le courant, la température ou l'état de charge dudit au moins un accumulateur ou leurs dérivées ou intégrales en fonction du temps ; **caractérisé en ce qu'**il comprend les étapes de :
   - calcul d'un état de santé intermédiaire à un instant donné $SOH_{int,n}$ défini comme le rapport de la valeur de la résistance à l'instant donné ($R_{mes,n}$) sur la valeur de la résistance de l'accumulateur à l'état neuf ($R_{new}$) dans les mêmes conditions de température ;
   - détermination en temps réel de l'état de santé de la batterie à l'instant donné ($SOH_n$) à partir de l'état de santé de la batterie à un instant précédent ($SOH_{n-1}$) corrigé en fonction de ladite résistance à l'instant donné ($R_{mes,n}$) et pondéré par le au moins un coefficient de confiance (G, H, I), et filtrage de l'état de santé SOHn dans lequel la valeur filtrée de l'état de santé est

$$SOH_n = \frac{x \cdot SOH_{n-1} + (G \cdot H \cdot I) \cdot SOH_{int,n}}{x + (G \cdot H \cdot I)}$$

   où x est la constante de temps du filtre.

2.   Le procédé de la revendication 1, comprenant en outre une étape de calcul d'un indice de confiance (IndConf_$SOH_n$) sur la valeur de l'état de santé de la batterie déterminée à l'instant donné ($SOH_n$), ledit indice de confiance étant calculé à partir de l'indice de confiance de l'instant précédent (IndConf_$SOH_{n-1}$) et du au moins un coefficient de confiance (G, H, I) avec IndConf_$SOH_n$= [x·IndConf_$SOH_{n-1}$ + (G · H · I)] / (x+1).

3.   Le procédé selon la revendication 2, dans lequel x va de 1000 s à 10000 s pour un pas de mesure de 100 ms.

4.   Le procédé de l'une des revendications précédentes, comprenant en outre une étape de filtrage temporel de la valeur de l'état de santé de la batterie déterminée à l'instant donné ($SOH_n$) avec une constante de temps du filtre (x) et un pas temporel de détermination $t_n$-$t_{n-1}$ choisie telle que le rapport (x / ($t_n$-$t_{n-1}$)) de la constante de temps du filtre sur le pas temporel de la détermination soit supérieur ou égal à $10^4$.

5.   Le procédé de l'une des revendications précédentes, comprenant en outre une étape de filtrage temporel de la valeur de la résistance déterminée à l'instant donné ($R_{mes,n}$) avec une constante de temps du filtre (r) et un pas temporel de détermination $t_n$-$t_{n-1}$ choisie telle que le rapport (r / ($t_n$-$t_{n-1}$)) de la constante de temps du filtre sur le pas temporel de la détermination soit supérieur ou égal à 1000.

6.   Le procédé de l'une des revendications précédentes, dans lequel un pas ($t_n$-$t_{n-1}$) de la détermination en temps réel est choisi entre 10 ms et 1 s.

7.   Le procédé de l'une des revendications 1 à 6, dans lequel la détermination de la résistance d'au moins un accumulateur à l'instant donné ($R_{mes,n}$) est réalisée par mesures de courant et de tension sur l'accumulateur.

8.   Le procédé de l'une des revendications 1 à 6, dans lequel la détermination de la résistance d'au moins un accumulateur à l'instant donné ($R_{mes,n}$) est réalisée par un algorithme de Kalman.

**9.** Système électronique de gestion d'un état de santé (SOH) d'une batterie comprenant au moins un accumulateur de courant, l'état de santé étant défini comme un état de vieillissement de la batterie entre un état neuf et un état en panne, le système comprenant :

    - des moyens de mesure de l'état de charge (SOC) d'au moins un accumulateur ;
    - des moyens de mesure en temps réel d'une résistance d'au moins un accumulateur ($R_{mes,n}$) ;
    - des moyens électroniques adaptés à mettre en oeuvre le procédé de détermination en temps réel de l'état de santé de la batterie selon l'une des revendications 1 à 8.

**10.** Le système électronique de la revendication 9, comprenant en outre des moyens de mesure en temps réel de la température d'au moins un accumulateur.

**11.** Le système électronique de la revendication 9 ou 10, comprenant en outre des moyens de contrôle de la charge et/ou de la décharge de la batterie en fonction de l'état de santé (SOH) déterminé.

**12.** Batterie (1) comprenant :

    - au moins un accumulateur électrochimique ;
    - un système électronique selon l'une des revendications 9 à 11.

**Patentansprüche**

**1.** Verfahren zur Bestimmung eines Gesundheitszustands (SOH) einer Batterie, die mindestens einen Stromakkumulator umfasst, wobei der Gesundheitszustand als ein Alterungszustand der Batterie zwischen einem Neuzustand und einem defekten Zustand definiert ist, wobei das Verfahren die folgenden Schritte umfasst:

    - Bestimmen eines Ladungszustands (SOC) mindestens eines Akkumulators;
    - Bestimmen, in Echtzeit, eines Widerstands mindestens eines Akkumulators ($R_{mes,n}$) ;
    - Bestimmen mindestens eines Vertrauenskoeffizienten (G, H, I), welcher der Zuverlässigkeit des Widerstands in Abhängigkeit von mindestens einer Variable Rechnung trägt, welche aus der Stromstärke, der Temperatur oder dem Ladungszustand des mindestens eines Akkumulators oder aus deren zeitabhängigen Ableitungen oder Integralen ausgewählt ist;
    **dadurch gekennzeichnet, dass** es die folgenden Schritte umfasst:
    - Berechnen eines Gesundheits-Zwischenzustands zu einem gegebenen Zeitpunkt $SOH_{int,n}$, welcher als Verhältnis aus dem Widerstandswert zu dem gegebenen Zeitpunkt ($R_{mes,n}$) und dem Widerstandswert des Akkumulators im Neuzustand ($R_{new}$) unter denselben Temperaturbedingungen definiert ist;
    - Bestimmen, in Echtzeit, des Gesundheitszustands der Batterie zu dem gegebenen Zeitpunkt ($SOH_n$), ausgehend von dem Gesundheitszustand der Batterie zu einem vorhergehenden Zeitpunkt ($SOH_{n-1}$), wobei dieser in Abhängigkeit von dem Widerstand zu dem gegebenen Zeitpunkt ($R_{mes,n}$) korrigiert und durch den mindestens einen Vertrauenskoeffizienten (G, H, I) gewichtet wird, sowie Filtern des Gesundheitszustands SOHn, wobei gefilterte Wert des Gesundheitszustands folgendermaßen beschaffen ist

$$SOH_n = \frac{x \cdot SOH_{n-1} + (G \cdot H \cdot I) \cdot SOH_{int,n}}{x + (G \cdot H \cdot I)}$$

wobei x die Zeitkonstante des Filters ist.

**2.** Verfahren des Anspruchs 1, das darüber hinaus einen Schritt umfasst in, welchem ein Vertrauensindex (IndConf_$SOH_n$) berechnet wird, der den Wert des Gesundheitszustands der Batterie betrifft, welcher zu dem gegebenen Zeitpunkt bestimmt wird ($SOH_n$), wobei der Vertrauensindex ausgehend vom vorhergehenden Vertrauensindex IndConf_$SOH_{n-1}$) und vom mindestens einen Vertrauenskoeffizienten (G, H, I) berechnet wird, wobei IndConf_$SOH_n = [x \cdot IndConf\_SOH_{n-1} + (G \cdot H \cdot I)] / (x+1)$.

**3.** Verfahren nach Anspruch 2, wobei x für eine Messwiederholrate von 100 ms im Bereich von 1000 s bis 10000 s liegt.

4. Verfahren eines der vorhergehenden Ansprüche, das darüber hinaus einen Schritt umfasst, in welchem der Wert des Gesundheitszustands der Batterie, der zu dem gegebenen Zeitpunkt bestimmt wurde ($SOH_n$), eine zeitliche Filterung erfährt, wobei eine Zeitkonstante des Filters (x) vorliegt und eine zeitliche Bestimmungswiederholrate $t_n-t_{n-1}$ derart gewählt wird, dass das Verhältnis $(x / (t_n-t_{n-1}))$ zwischen der Zeitkonstante des Filters und der zeitlichen Bestimmungswiederholrate mindestens $10^4$ beträgt.

5. Verfahren eines der vorhergehenden Ansprüche, das darüber hinaus einen Schritt umfasst, in welchem der Wert des Widerstands, der zu dem gegebenen Zeitpunkt bestimmt wurde ($R_{mes,n}$), eine zeitliche Filterung erfährt, wobei eine Zeitkonstante des Filters (r) vorliegt und eine zeitliche Bestimmungswiederholrate $t_n-t_{n-1}$ derart gewählt wird, dass das Verhältnis $(r / (t_n-t_{n-1}))$ zwischen der Zeitkonstante des Filters und der zeitlichen Bestimmungswiederholrate mindestens 1000 beträgt.

6. Verfahren eines der vorhergehenden Ansprüche, bei wobei eine zeitliche Bestimmungswiederholrate $(t_n-t_{n-1})$ in Echtzeit derart gewählt wird, das sie zwischen 10 ms und 1 s beträgt.

7. Verfahren eines der Ansprüche 1 bis 6, bei welchem die Bestimmung des Widerstandes eines Akkumulators zu dem gegebenen Zeitpunkt ($R_{mes,n}$) erfolgt, indem an dem Akkumulator Stromstärken- und Spannungsmessungen vorgenommen werden.

8. Verfahren eines der Ansprüche 1 bis 6, bei welchem die Bestimmung des Widerstandes eines Akkumulators zu dem gegebenen Zeitpunkt ($R_{mes,n}$) mittels eines Kalman-Algorithmus erfolgt.

9. Elektronisches System zur Verwaltung eines Gesundheitszustands (SOH) einer Batterie, die mindestens einen Stromakkumulator umfasst, wobei der Gesundheitszustand als ein Alterungszustand der Batterie zwischen einem Neuzustand und einem defekten Zustand definiert ist, wobei das System Folgendes umfasst:

- Mittel zur Messung des Ladungszustands (SOC) des mindestens einen Akkumulators;
- Mittel zur Echtzeit-Messung eines Widerstands mindestens eines Akkumulators ($R_{mes,n}$) ;
- elektronische Mittel, die dazu geeignet sind, das Verfahren zur Echtzeit-Bestimmung des Gesundheitszustands der Batterie nach einem der Ansprüche 1 bis 8 durchzuführen.

10. Elektronisches System des Anspruchs 9, welches darüber hinaus Mittel zur Echtzeit-Messung der Temperatur mindestens eines Akkumulators umfasst.

11. Elektronisches System des Anspruchs 9 oder 10, welches darüber hinaus Mittel zur Steuerung des Ladens und/ oder Entladens der Batterie in Abhängigkeit des bestimmten Gesundheitszustands (SOH) umfasst.

12. Batterie (1), umfassend:

- mindestens einen elektrochemischen Akkumulator;
- ein elektronisches System nach einem der Ansprüche 9 bis 11.

**Claims**

1. A method for determining the state of health (SOH) of a battery comprising at least one rechargeable cell, state of health being defined as a state of ageing of the battery between a new state and a state where it is faulty, the method including the steps of:

- determining a state of charge (SOC) for at least one cell;
- determining in real time a resistance of at least one cell ($R_{mes,n}$);
- determining at least one confidence coefficient (G, H, I) accounting on reliability of the resistance as a function of at least one variable selected from current, temperature or state of charge of the at least one rechargeable cell, or the derivatives or integrals thereof with respect to time;
**characterized in that** it includes the steps of:
- calculating an intermediate value for state of health for a given point in time ($SOH_{int,n}$) defined as the ratio of resistance at the given point in time ($R_{mes,n}$) to resistance of the cell in a new state ($R_{new}$) under the same temperature conditions,

- determining in real time the state of health of the battery at a given point in time (SOH$_n$), using the state of health of the battery at a preceding point in time (SOH$_{n-1}$) corrected as a function of said resistance at the given point in time (R$_{mes,n}$) and weighted by the at least one confidence coefficient (G, H, I), and filtering of the state of health SOH$_n$ ;

wherein the filtered value of state of health is

$$SOH_n = \frac{x \cdot SOH_{n-1} + (G \cdot H \cdot I) \cdot SOH_{int,n}}{x + (G \cdot H \cdot I)}$$

where x is the filter time constant.

2. The method according to claim 1, further comprising calculating an index of confidence (IndConf_SOH$_n$) for the value of the state of health of the battery determined at the given point in time (SOH$_n$), said index of confidence being calculated from an index of confidence at the preceding point in time (IndConf_SOH$_{n-1}$) and from at least one index of confidence (G, H, I) with IndConf_SOH$_n$= [x•IndConf_SOH$_{n-1}$ + (G · H · I)] / (x+1).

3. The method according to claim 2, wherein the value of x ranges from 1000 to 10000 s for a 100 ms measurement step.

4. The method according to one of the preceding claims, further including filtering in the time domain the value of the state of health of the battery determined at said given point in time (SOH$_n$), using a filter time constant (x) and a filter time step (t$_n$-t$_{n-1}$) selected such that a ratio of filter time constant to time step of the determination (x/t$_n$-t$_{n-1}$) is greater than or equal to $10^4$.

5. The method according to one of the preceding claims, further including filtering in the time domain the value of the resistance determined at the given point in time (R$_{mes,n}$) using a filter time constant (r) and a filter time step (t$_n$-t$_{n-1}$) selected such that a ratio of filter time constant to time step of the determination (r/(t$_n$-t$_{n-1}$)) is greater than or equal to 1000.

6. The method according to one of the preceding claims, in which a time step (t$_n$-t$_{n-1}$) for the real time determination is chosen between 10 ms and 1 s.

7. The method according to one of claims 1 to 6, in which determination of the resistance of at least one cell at the given point in time (R$_{mes,n}$) is performed by measuring cell current and voltage.

8. The method according to one of claims 1 to 6, in which determination of the resistance of at least one cell at the given point in time (R$_{mes,n}$) is performed using a Kalman algorithm.

9. An electronic system for managing a state of health (SOH) of a battery comprising at least one rechargeable cell, state of health being defined as a state of ageing of the battery between a new state and a state where it is faulty, the system including:

   - means for measuring state of charge (SOC) of at least one cell,
   - means for measuring in real time a resistance (R$_{mes,n}$) of at least one cell;
   - electronic means adapted to determine a state of charge (SOC) for at least one cell;
   - electronic means adapted for implementing the real-time method for determining state of health of the battery according to one of claims 1 to 8.

10. The electronic system according to claim 9, further including means for measuring in real time temperature of at least one cell.

11. The electronic system according to claim 9 or 10, further including means for controlling battery charging and/or discharge as a function of the state of health (SOH) determined.

12. A battery comprising:

- at least one electrochemical cell;
- an electronic system according to one of claims 9 to 1 l.

Figure 1

Figure 2

Figure 3

Figure 4

Seuil SOH
(%/min)

aa

0

-bb

-aa

$R_{mes,n}/R_n$

Figure 5

| 10 | I | | |
| | V | 100 | |
| | T | | |

Chargeur
/
Application

+

-

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 7202632 A
- US 7009401 A
- US 7324902 A
- US 7072871 A
- US 654954 A
- US 20060111854 A
- EP 1688754 A

**Littérature non-brevet citée dans la description**

- **J. LEE et al.** Li-ion battery SOC estimation method based on the reduced order Kalman filtering. *Journal of power source,* 2007, vol. 174 (9-15